# EUROPEAN PATENT SPECIFICATION

(11) **EP 4 449 573 B1**
(45) Date of publication and mention of the grant of the patent: **28.10.2026**
(21) Application number: 21844126.9
(22) Date of filing: 16.12.2021
(51) Int. Cl.: H02J 3/38, H02J 3/40, H02P 9/00

(54) **SYSTEM AND METHOD FOR DECOUPLING CURRENT COMMAND COMPONENTS IN A SYNCRONOUSLY-ROTATING FRAME**
SYSTEM UND VERFAHREN ZUR ENTKOPPLUNG VON STROMBEFEHLSKOMPONENTEN IN EINEM SYNCHRON ROTIERENDEN RAHMEN
SYSTÈME ET PROCÉDÉ POUR DÉCOUPLER DES COMPOSANTS DE COMMANDE DE COURANT DANS UN CADRE À ROTATION SYNCHRONE

(43) Date of publication of application: 23.10.2024
(73) Proprietor: General Electric Renovables España, S.L., 08005 Barcelona (ES)
(72) Inventor: BERROTERAN, Igor, Roanoke Boulevard Salem, Virginia 24153 (US); HOWARD, Dustin, Schenectady, New York 12345 (US); ACHILLES, Alfredo Sebastian, Schenectady, New York 12345 (US)
(74) Representative: Zimmermann & Partner Patentanwälte mbB
(86) International application number: PCT/US2021/063774
(87) International publication number: WO 2023/113801

(56) References cited:
- US-A1- 2020 191 116
- MAKINEN A S ET AL: "Influence of DFIG reactive current injection during a voltage dip on the operation of wind turbine circuit breaker", POWER ELECTRONICS AND ECCE ASIA (ICPE&ECCE), 2011 IEEE 8TH INTERNATIONAL CONFERENCE ON, IEEE, 30 May 2011 (2011-05-30), pages 88 - 95, XP031956147, ISBN: 978-1-61284-958-4, DOI: 10.1109/ICPE.2011.5944551
- DIAO LIANG ET AL: "Sensorless control of a stand-alone Doubly fed induction machine for ship shaft generator systems", FIFTH INTERNATIONAL CONFERENCE ON INTELLIGENT CONTROL AND INFORMATION PROCESSING, IEEE, 18 August 2014 (2014-08-18), pages 373 - 377, XP032720112, ISBN: 978-1-4799-3649-6, [retrieved on 20150114], DOI: 10.1109/ICICIP.2014.7010281
- ZAIMEDDINE R ET AL: "Control of a grid-connected double-fed induction generator wind turbine", 2011 IEEE TRONDHEIM POWERTECH : TRONDHEIM, NORWAY, 19 - 23 JUNE 2011, IEEE, PISCATAWAY, NJ, 19 June 2011 (2011-06-19), pages 1 - 7, XP032263686, ISBN: 978-1-4244-8419-5, DOI: 10.1109/PTC.2011.6019462

## Description

### FIELD

The present disclosure relates in general to power generation, and more particularly to systems and methods for decoupling current command components in rotating frames with calculated reference nodes.

### BACKGROUND

Power generating assets may take a variety of forms and may include assets which rely on renewable and/or nonrenewable sources of energy. Those power generating assets which rely on renewable sources of energy may generally be considered one of the cleanest, most environmentally friendly energy sources presently available. For example, wind turbines have gained increased attention in this regard. A modem wind turbine typically includes a tower, a generator, a gearbox, a nacelle, and one or more rotor blades. The nacelle includes a rotor assembly coupled to the gearbox and to the generator. The rotor assembly and the gearbox are mounted on a bedplate support frame located within the nacelle. The rotor blades capture kinetic energy of wind using known airfoil principles. The rotor blades transmit the kinetic energy in the form of rotational energy so as to turn a shaft coupling the rotor blades to a gearbox, or if a gearbox is not used, directly to the generator. The generator then converts the mechanical energy to electrical energy and the electrical energy may be transmitted to a converter and/or a transformer housed within the tower and subsequently deployed to a utility grid. Modern wind power generation systems typically take the form of a wind farm having multiple wind turbine generators that are operable to supply power to a transmission system providing power to an electrical grid.

Wind turbines can be distinguished in two types: fixed speed and variable speed turbines. Conventionally, variable speed wind turbines are controlled as current sources connected to an electrical grid. In other words, the variable speed wind turbines rely on a grid frequency detected by a phase locked loop (PLL) as a reference and inject a specified amount of current into the grid. The conventional current source control of the wind turbines is based on the assumptions that the grid voltage waveforms are fundamental voltage waveforms with fixed frequency and magnitude and that the penetration of wind power into the grid is low enough so as to not cause disturbances to the grid voltage magnitude and frequency. Thus, the wind turbines simply inject the specified current into the grid based on the fundamental voltage waveforms. However, with the rapid growth of the wind power, wind power penetration into some grids has increased to the point where wind turbine generators have a significant impact on the grid voltage and frequency. When wind turbines are located in a weak grid, wind turbine power fluctuations may lead to an increase in magnitude and frequency variations in the grid voltage. These fluctuations may adversely affect the performance and stability of the PLL and wind turbine current control.

Furthermore, existing controls for doubly-fed induction generator (DFIG) wind turbine systems with three-winding grid-interfacing transformers estimate primary-side transformer voltage to lock its phase reference (PLL). Once this phase is locked, angular information of feedback signals is used to transform typical three-phase power system (which uses an a-b-c reference frame) into a two-phase system (which uses a d-q reference frame). A proper selection of this phase refence also allows decoupling of the active and reactive current control loops. Therefore, this control structure assumes decoupled control of active and reactive components of current. However, the PLL reference node being separate from the voltage and current feedback nodes introduces coupling between active and reactive components of current. US2020/191116A1 describes a system and method for controlling voltage of a DC link of a power converter of an electrical power system.

Thus, the present disclosure is directed to a system and method for decoupling current command components in rotating frames with calculated reference nodes to address the aforementioned issues. More specifically, the present disclosure describes how compensation terms on the current command components can be introduced to significantly reduce a coupling effect that active and reactive current regulation loops have on each other.

### BRIEF DESCRIPTION

Aspects and advantages of the invention will be set forth in part in the following description, or may be obvious from the description, or may be learned through practice of the invention.

In one aspect, the present disclosure is directed to a method for controlling a power generating asset having a generator. The generator has a stator operably coupled to a transformer and a rotor operably coupled to the transformer via a power converter. The method includes using, via a controller, an angle of a phase-locked loop (PLL) reference signal of a PLL at a PLL reference node of the power generating asset to transform a three-phase set of signals to a two-dimensional orthogonal coordinate system of a synchronously-rotating frame. The two-dimensional orthogonal coordinate system include x and y components of at least one of voltage and current. The method also includes determining, via the controller, one or more dynamic decoupling factors as a function of one or more of the x and y components of voltage and current. Further, the method includes applying, via the controller, the one or more dynamic decoupling factors to current command calculation logic to mitigate a coupling effect of one or more current command components. The method may further include any of the additional steps and/or features described herein.

In another aspect, the present disclosure is directed to a system for operating power generating asset. The system includes a generator connected to a power grid and a controller communicatively coupled to the generator. The controller includes at least one processor configured to perform a plurality of operations, including but not limited to using an angle of a phase-locked loop (PLL) reference signal of a PLL at a PLL reference node of the power generating asset to transform a three-phase set of signals to a two-dimensional orthogonal coordinate system of a synchronously-rotating frame, the two-dimensional orthogonal coordinate system including x and y components of at least one of voltage and current, determining one or more dynamic decoupling factors as a function of one or more of the x and y components of at least one of voltage and current, and applying the one or more dynamic decoupling factors to current command calculation logic to mitigate a coupling effect of one or more current command components. The plurality of operations may include any of the operations and/or features described herein.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWINGS

A full and enabling disclosure of the present invention, including the best mode thereof, directed to one of ordinary skill in the art, is set forth in the specification, which makes reference to the appended figures, in which:
FIG. 1 illustrates a perspective view of one embodiment of a power generating asset configured as a wind turbine according to the present disclosure;
FIG. 2 illustrates a schematic diagram of one embodiment of an electrical system for use with the power generating asset according to the present disclosure;
FIG. 3 illustrates a block diagram of one embodiment of a controller for use with the power generating asset according to the present disclosure;
FIG. 4 illustrates an embodiment of a control diagram for current command compensation, particularly illustrating calculation of an x component of a stator compensation command;
FIG. 5 illustrates an embodiment of a control diagram for current command compensation, particularly illustrating calculation of a y component of a stator compensation command;
FIG. 6 illustrates a flow diagram of one embodiment of a method for controlling a power generating asset according to the present disclosure;
FIG. 7 illustrates an embodiment of a control diagram for calculating first and second dynamic decoupling x- and y-factors according to the present disclosure;
FIG. 8 illustrates a schematic diagram of an embodiment of a rotating frame (e.g., the two-dimensional synchronously-rotating frame described herein) according to the present disclosure; and
FIG. 9 illustrates an embodiment of a control diagram for applying the first and second dynamic decoupling x- and y-factors to the current command calculation logic to mitigate the coupling effect of the current command component(s) according to the present disclosure.

Repeat use of reference characters in the present specification and drawings is intended to represent the same or analogous features or elements of the present invention.

### DETAILED DESCRIPTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

As used herein, the terms "first", "second", and "third" may be used interchangeably to distinguish one component from another and are not intended to signify location or importance of the individual components.

The terms "coupled," "fixed," "attached to," and the like refer to both direct coupling, fixing, or attaching, as well as indirect coupling, fixing, or attaching through one or more intermediate components or features, unless otherwise specified herein.

Approximating language, as used herein throughout the specification and claims, is applied to modify any quantitative representation that could permissibly vary without resulting in a change in the basic function to which it is related. Accordingly, a value modified by a term or terms, such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

Here and throughout the specification and claims, range limitations are combined and interchanged, such ranges are identified and include all the sub-ranges contained therein unless context or language indicates otherwise. For example, all ranges disclosed herein are inclusive of the endpoints, and the endpoints are independently combinable with each other.

Generally, the present disclosure is directed to systems and methods for controlling a power generating asset, such as a wind turbine, connected to an electrical grid. In particular, the systems and methods disclosed herein may be employed to introduce reactive current command compensation after any algorithm that efficiently distributes net current flow between secondary transformer windings. Moreover, the systems and methods disclosed herein may be employed to define new dynamic decoupling factors based on ratio of voltage feedback magnitude to individual components. In addition, the systems and methods disclosed herein may be employed to cancel a coupling effect by adding a product of uncompensated commands and dynamic decoupling factors to existing current command calculation logic. It should be further appreciated that such a decoupling of the drivetrain shaft power from the active power injected into the electrical grid may be desirable in both grid-following and grid-forming applications.

Accordingly, the present disclosure is configured to provide numerous benefits not present in the prior art. For example, new compensation terms are intended to improve performance aspects of existing DFIG converter controls, in the areas of steady state discrepancy elimination between line and stator current control, positive sequence reactive current injection during unbalanced faults, voltage stability for unbalanced grid faults, and/or ride-through capability for remote faults. Thus, the present disclosure is configured to eliminate wasted converter current capability by preventing unnecessary circulating reactive current between the line-side converter and the generator stator, reduce the number of wind turbine trips when subjected to remote grid faults, improve voltage stability compliance under grid disturbance, and/or improve reactive current K-factor compliance, where K-factor is a voltage-variation to current-variation proportionality number during grid events, commonly required by grid codes.

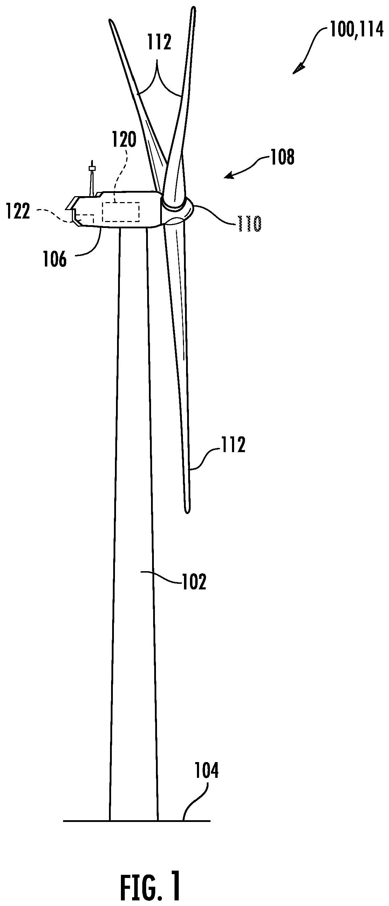

Referring now to the drawings, FIG. 1 illustrates a perspective view of one embodiment of a power generating asset 100 according to the present disclosure. As shown, the power generating asset 100 may be configured as a wind turbine 114. In an additional embodiment, the power generating asset 100 may, for example, be configured as a solar power generating asset, a hydroelectric plant, a fossil fuel generator, and/or a hybrid power generating asset.

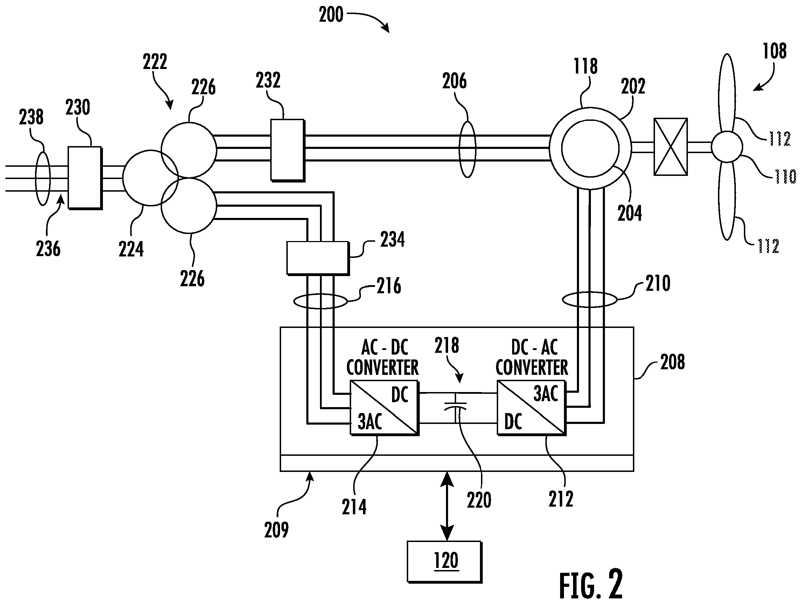

When configured as a wind turbine 114, the power generating asset 100 may generally include a tower 102 extending from a support surface 104, a nacelle 106, mounted on the tower 102, and a rotor 108 coupled to the nacelle 106. The rotor 108 includes a rotatable hub 110 and at least one rotor blade 112 coupled to and extending outwardly from the hub 110. For example, in the illustrated embodiment, the rotor 108 includes three rotor blades 112. However, in an alternative embodiment, the rotor 108 may include more or less than three rotor blades 112. Each rotor blade 112 may be spaced about the hub 110 to facilitate rotating the rotor 108 to enable kinetic energy to be transferred from the wind into usable mechanical energy, and subsequently, electrical energy. For instance, the hub 110 may be rotatably coupled to an electric generator 118 (FIG. 2) of an electrical system 200 (FIG. 2) positioned within the nacelle 106 to permit electrical energy to be produced.

The wind turbine 114 may also include a controller 120 centralized within the nacelle 106. However, in other embodiments, the controller 120 may be located within any other component of the wind turbine 114 or at a location outside the wind turbine. Further, the controller 120 may be communicatively coupled to any number of the components of the wind turbine 114 in order to control the components. As such, the controller 120 may include a computer or other suitable processing unit. Thus, in several embodiments, the controller 120 may include suitable computer-readable instructions that, when implemented, configure the controller 120 to perform various different functions, such as receiving, transmitting and/or executing wind turbine control signals.

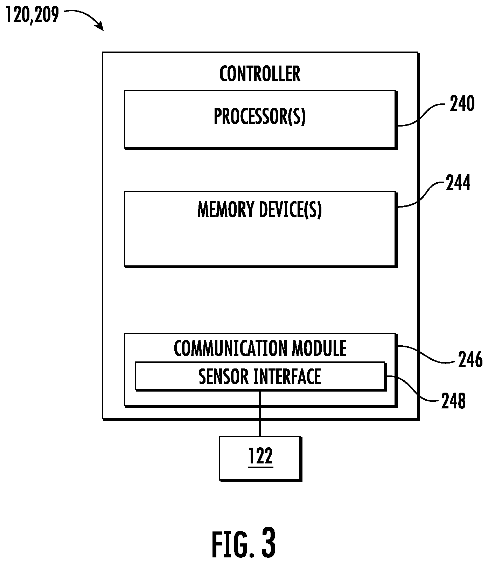

As depicted in FIGS. 1 and 3, in an embodiment, the power generating asset 100 may also include at least one operational sensor 122. The operational sensor(s) 122 may be configured to detect a performance of the power generating asset 100 and/or an environmental or wind condition. In an embodiment, the operational sensor(s) 122 may be configured to monitor a plurality of electrical conditions, such as slip, stator voltage and current, rotor voltage and current, line-side voltage and current, DC-link charge and/or any other electrical condition of the power generating asset.

It should also be appreciated that, as used herein, the term "monitor" and variations thereof indicates that the various sensors of the power generating asset 100 may be configured to provide a direct measurement of the parameters being monitored or an indirect measurement of such parameters. Thus, the sensors described herein may, for example, be used to generate signals relating to the parameter being monitored, which can then be utilized by the controller 120 to determine a condition or response of the power generating asset 100.

Referring now to FIG. 2, wherein an exemplary electrical system 200 of the power generating asset 100 is illustrated. As shown, the generator 118 may be coupled to the rotor 108 for producing electrical power from the rotational energy generated by the rotor 108. Accordingly, in an embodiment, the electrical system 200 may include various components for converting the kinetic energy of the rotor 108 into an electrical output in an acceptable form to a connected power grid 238. For example, in an embodiment, the generator 118 may be a double-fed induction generator (DFIG) having a stator 202 and a generator rotor 204. The generator 118 may be coupled to a stator bus 206 and a power converter 208 via a rotor bus 210. In such a configuration, the stator bus 206 may provide an output multiphase power (e.g., three-phase power) from the stator 202 of the generator 118, and the rotor bus 210 may provide an output multiphase power (e.g., three-phase power) of the generator rotor 404 of the generator 118. Additionally, the generator 118 may be coupled via the rotor bus 210 to a rotor side converter 212. The rotor side converter 212 may be coupled to a line-side converter 214 which, in turn, may be coupled to a line-side bus 216.

In an embodiment, the rotor side converter 212 and the line-side converter 214 may be configured for normal operating mode in a three-phase, pulse width modulation (PWM) arrangement using insulated gate bipolar transistors (IGBTs) as switching devices. Other suitable switching devices may be used, such as insulated gate commuted thyristors, MOSFETs, bipolar transistors, silicone-controlled rectifiers, and/or other suitable switching devices. The rotor side converter 212 and the line-side converter 214 may be coupled via a DC link 218 across a DC link capacitor 220.

In an embodiment, the power converter 208 may be coupled to a converter controller 209 and/or the controller 120, which is configured to control the operation of the power converter 208. For example, the converter controller 209 may send control commands to the rotor side converter 212 and the line-side converter 214 to control the modulation of switching elements used in the power converter 208 to establish a desired generator torque setpoint and/or power output.

As further depicted in FIG. 2, the electrical system 200 may, in an embodiment, include a transformer 222 coupling the power generating asset of 100 to the electrical grid 238 via a point of interconnect (POI) 236. The transformer 222 may, in an embodiment, be a 3-winding transformer which includes a high voltage (e.g., greater than 12 KVAC) primary winding 224. The high voltage primary winding 224 may be coupled to the electrical grid 238. The transformer 222 may also include a medium voltage (e.g., 6 KVAC) secondary winding 226 coupled to the stator bus 206 and a low voltage (e.g., 575 VAC, 690 VAC, etc.) auxiliary winding 228 coupled to the line bus 216. It should be appreciated that the transformer 222 can be a three-winding transformer as depicted, or alternatively, may be a two-winding transformer having only a primary winding 224 and a secondary winding 226; may be a four-winding transformer having a primary winding 224, a secondary winding 226, and auxiliary winding 228, and an additional auxiliary winding; or may have any other suitable number of windings.

In an embodiment, the electrical system 200 may include various protective features (e.g., circuit breakers, fuses, contactors, and other devices) to control and/or protect the various components of the electrical system 200. For example, the electrical system 200 may, in an embodiment, include a grid circuit breaker 230, a stator bus circuit breaker 232, and/or a line bus circuit breaker 234. The circuit breaker(s) 230, 232, 234 of the electrical system 200 may connect or disconnect corresponding components of the electrical system 200 when a condition of the electrical system 200 approaches a threshold (e.g., a current threshold and/or an operational threshold) of the electrical system 200.

Referring now to FIG. 3, a schematic diagram of one embodiment of suitable components that may be included within the controller 120 is illustrated. For example, as shown, the controller 120 is communicatively coupled to the sensor(s) 122. Further, as shown, the controller 120 includes one or more processor(s) 240 and associated memory device(s) 242 configured to perform a variety of computer-implemented functions (e.g., performing the methods, steps, calculations and the like and storing relevant data as disclosed herein). Additionally, the controller 120 may also include a communications module 246 to facilitate communications between the controller 120 and the various components of the power generating asset 100. Further, the communications module 246 may include a sensor interface 248 (e.g., one or more analog-to-digital converters) to permit signals transmitted from the sensor(s) 122 to be converted into signals that can be understood and processed by the processor(s) 240. It should be appreciated that the sensor(s) 122 may be communicatively coupled to the communications module 246 using any suitable means. For example, the sensor(s) 122 may be coupled to the sensor interface 248 via a wired connection. However, in other embodiments, the sensor(s) 122 may be coupled to the sensor interface 248 via a wireless connection, such as by using any suitable wireless communications protocol known in the art.

As used herein, the term "processor" refers not only to integrated circuits referred to in the art as being included in a computer, but also refers to a controller, a microcontroller, a microcomputer, a programmable logic controller (PLC), an application specific integrated circuit, and other programmable circuits. Additionally, the memory device(s) 242 may generally comprise memory element(s) including, but not limited to, computer readable medium (e.g., random access memory (RAM)), computer readable non-volatile medium (e.g., a flash memory), a floppy disk, a compact disc-read only memory (CD-ROM), a magneto-optical disk (MOD), a digital versatile disc (DVD) and/or other suitable memory elements. Such memory device(s) 242 may generally be configured to store suitable computer-readable instructions that, when implemented by the processor(s) 240, configure the controller 120 to perform various functions as described herein, as well as various other suitable computer-implemented functions.

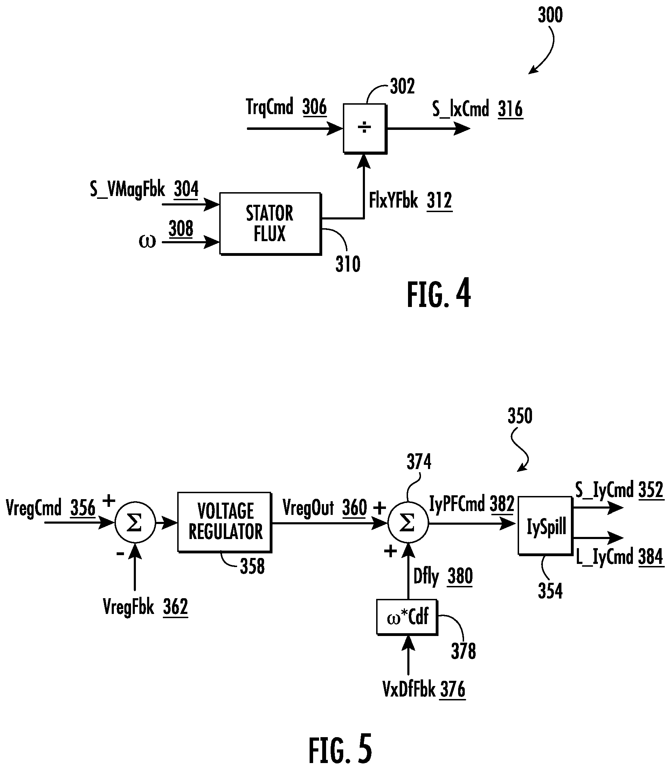

Referring now to FIGS. 4 and 5, example control diagrams 300, 350 for current command compensation are illustrated. In particular, as shown, FIG. 4 illustrates control logic 300 for calculating an x component of a stator current command 316 (S_IxCmd), whereas FIG. 5 illustrates control logic 350 for calculating a y component of a stator compensation command 352 (S_IyCmd). More specifically, as shown in FIG. 4, the control logic 300 receives a stator voltage feedback signal 304 (S_VMagFbk), an angular frequency 308 (ω), , and a torque command signal 306. Thus, as shown, a stator flux block 310 determines a component of a flux signal 312 (FlxYFbk) using the stator voltage feedback signal 304 (S_VMagFbk) and the angular frequency 308 (ω). Accordingly, as shown at divider 302, the control logic 300 is configured to divide the torque command signal 306 by the flux signal 312 (FlxYFbk). Thus, as shown, the output of the divider 302 is the x component of the stator current command 352 (S_IyCmd).

Furthermore, as shown in FIG. 5, the control logic 350 receives a voltage regulator command 356 (VregCmd) and a voltage regulator feedback signal 362 (VregFbk). Thus, as shown at 358, the control logic 350 is configured to input a difference between the voltage regulator command 356 (VregCmd) and the voltage regulator feedback signal 362 (VregFbk) into a voltage regulator block 358 to obtain a voltage regulator output signal 360 (VregOut). Moreover, as shown at 378, the control logic 350 receives an x component of voltage feedback 376 (VxDfFbk, where Df represents a distortion filter) and multiplies this value by ω*Cdf to obtain Dfly 380. Accordingly, as shown at summator 374, the voltage regulator output signal 360 (VregOut) and Dfly 380 are added together to obtain a y component of a current command (IyPFCmd 382). Thus, as shown at 354, a line/stator split 354 (IySpill) is provided to split the y component of the current command (IyPFCmd 382) to each of the stator (S_IyCmd 352) and the line side converter (L_LyCmd 384).

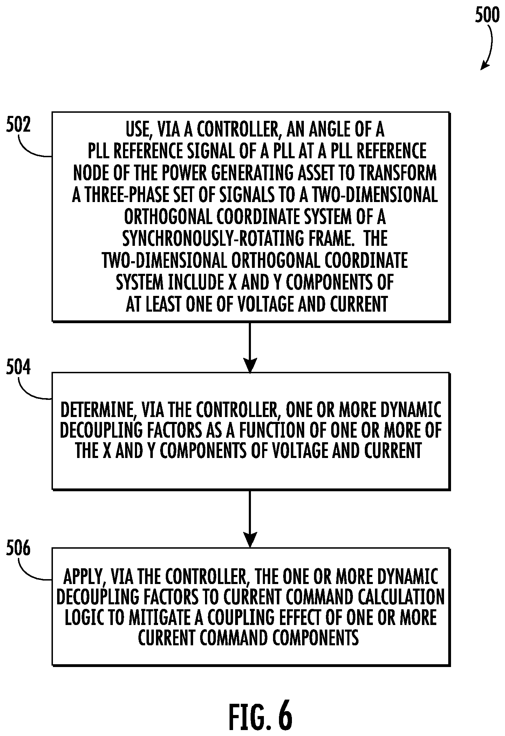

More specifically, as shown in FIG. 5, the y component of the stator compensation command 352 (S_IyCmd) is introduced before the line/stator split 354 (IySpill). In such embodiments, there is no compensation of the distortion filter Iy compensation. Thus, referring now to FIGS. 6-9, various embodiments of a system and method for controlling a power generating asset are provided according to the present disclosure to describe how compensation terms on current command components can be introduced to significantly reduce coupling effect that active and reactive current regulation loops have on each other are provided. In such embodiments, these new decoupling factors are introduced to improve performance, since PLL and feedback nodes are different. In particular, FIG. 6 illustrates a flow diagram of one embodiment of a method 500 for controlling a power generating asset according to the present disclosure. The method 500 may be implemented using, for instance, the power generating asset 100 discussed herein. FIG. 6 depicts steps performed in a particular order for purposes of illustration and discussion. Those of ordinary skill in the art, using the disclosures provided herein, will understand that various steps of the method 500, or any of the methods disclosed herein, may be adapted, modified, rearranged, performed simultaneously, or modified in various ways without deviating from the scope of the present disclosure.

As shown at (502), the method 500 includes using, via a controller, an angle of a phase-locked loop (PLL) reference signal of a PLL at a PLL reference node of the power generating asset to transform a three-phase set of signals to a two-dimensional orthogonal coordinate system of a synchronously-rotating frame. The two-dimensional orthogonal coordinate system include x and y components of at least one of voltage and current. As shown at (504), the method 500 may include determining, via the controller, one or more dynamic decoupling factors as a function of one or more of the x and y components of at least one of voltage and current.

As shown at (506), the method 500 may include applying, via the controller, the one or more dynamic decoupling factors to current command calculation logic to mitigate a coupling effect of one or more current command components. For example, in an embodiment, the coupling effect of the one or more current command components occurs between active and reactive current command components.

For example, in an embodiment, applying the dynamic decoupling factor(s) to the current command calculation logic to mitigate the coupling effect of one or more current command components may include observing an approach of a first dynamic decoupling x-factor and a second dynamic decoupling y-factor to zero as the x component of voltage aligns with an x-axis of the two-dimensional synchronously-rotating frame. In such embodiments, if the first dynamic decoupling x-factor and the second dynamic decoupling y-factor both approach zero as the x component of voltage aligns with the x-axis of the two-dimensional synchronously-rotating frame, then the first dynamic decoupling x-factor and the second dynamic decoupling y-factor have no effect on the current command calculation logic.

However, if the first dynamic decoupling x-factor and the second dynamic decoupling y-factor do not both approach zero as the x component of voltage aligns with the x-axis of the two-dimensional synchronously-rotating frame, then one can conclude that one or more feedback and reference node disparities exist in the power generating asset and the first and second dynamic decoupling x- and y-factors provide dynamic measures of how much one or more of the current command components needs to be adjusted in order to obtain a desired net current at the PLL reference node. Thus, the first and second dynamic decoupling x- and y-factors are applied to the current command calculation logic to mitigate the coupling effect of the current command component(s).

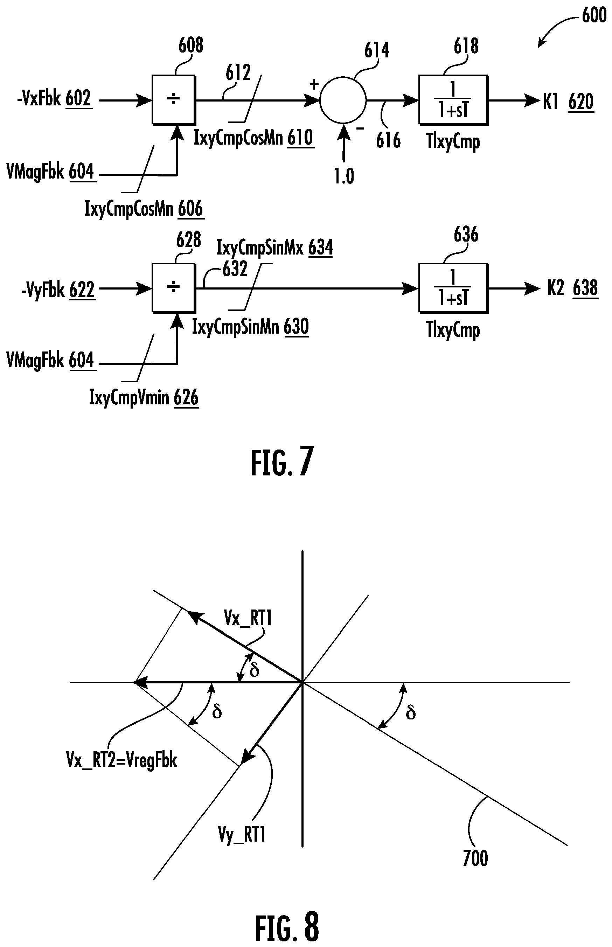

The method 500 of FIG. 6 can be better understood with reference to FIGS. 7-9. In particular, as shown in FIGS. 7 and 8, control logic 600 for calculating the dynamic decoupling factors 620, 638 (e.g., K1 and K2) is provided. In particular, as shown, the control logic 600 is configured to determine a first dynamic decoupling x-factor 620 as a function of one or more of the x and y components of voltage and current and a second dynamic decoupling y-factor 638 as a function of one or more of the x and y components of voltage and current. More specifically, as shown, the control logic 600 is configured to receive an x component of voltage 602 (-VxFbk) and a voltage magnitude 604 (VMagFbk). Thus, as shown at divider 608, the control logic 600 is configured to determine the first dynamic decoupling x-factor 620 based on a quotient 612 of the x component of voltage 602 (-VxFbk) over the voltage magnitude 604 (VMagFbk). Moreover, as shown, in certain embodiments, the quotient 612 may also be limited by a minimum value 610 (IxyCmpCosMn). Thus, as shown at summator 614, the control logic 600 is configured to determine a difference 616 between the quotient 612 and unity (1.0). The difference 616 can then be filtered as shown via a low-pass filter 618 to determine the first dynamic decoupling x-factor 620. It should be further understood that any suitable clamping and/or filtering can be applied to the x and y components of voltage and current as needed.

Still referring to FIG. 6, the control logic 600 is configured to determine the second dynamic decoupling y-factor 638 as a function of one or more of the x and y components of voltage and current. More specifically, as shown, the control logic 600 is configured to receive a y component of voltage 622 (-VyFbk) and the voltage magnitude 604 (VMagFbk). Thus, as shown at divider 628, the control logic 600 is configured to determine the second dynamic decoupling y-factor 638 based on a quotient 632 of the y component of voltage 622 (-VyFbk) over the voltage magnitude 604 (VMagFbk). Moreover, as shown, in certain embodiments, the quotient 632 may also be limited by a minimum value 630 (IxyCmpSinMn) and a maximum value 634 (IxyCmpSinMx). Thus, as shown, the quotient 632 can then be filtered as shown via a low-pass filter 636 to determine the second dynamic decoupling y-factor 638. **In** further embodiments, it should be understood that any suitable clamping and/or filtering can be applied to the x and y components of voltage and current as needed.

For example, in an embodiment, as shown in FIG. 8, a schematic diagram of an embodiment of a rotating frame 700 (e.g., the two-dimensional synchronously-rotating frame described herein) is illustrated. Thus, within the rotating frame 700, the relationships amongst the voltage feedbacks are provided. In particular, as shown, angle (δ) represents the angle of the PLL reference signal described herein. Thus, the first and second dynamic decoupling x- and y-factors 620, 638 may be calculated using the trigonometric functions provided in Equations (2) and (3) below: $cos \left(δ\right) = \frac{Vx _ RT 1}{VmagFbk}$ Equation (2) $sin \left(δ\right) = \frac{Vy _ RT 1}{VmagFbk}$ Equation (3)

In such embodiments, the voltage magnitude of the PLL reference signal may be determined as a function of the x and y components of voltage. More specifically, in an embodiment, the voltage magnitude may be calculated using a square root of a summation of the x and y components of voltage squared, as provided in Equation (4) below: $VmagFbk = \sqrt{{{V}_{x}}^{2} + {{V}_{y}}^{2}}$ Equation (4)

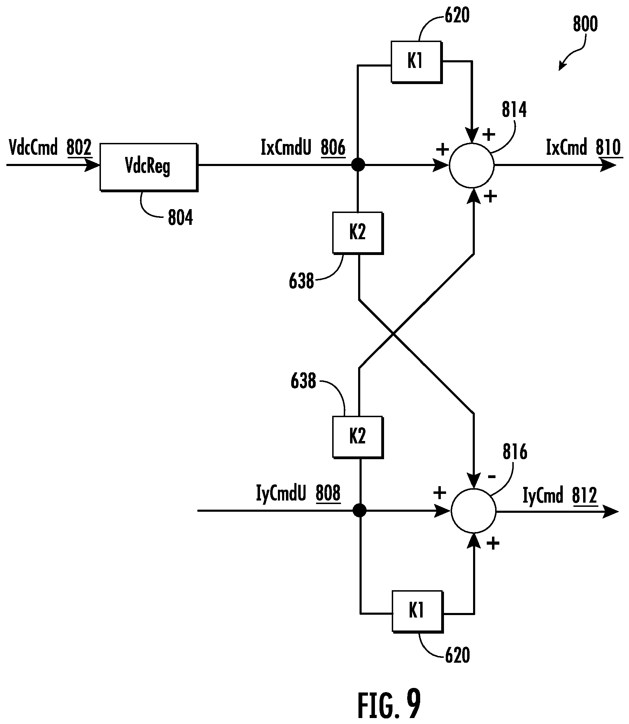

Referring now to FIG. 9, control logic 800 for applying the first and second dynamic decoupling x- and y-factors 620, 638 to the current command calculation logic to mitigate the coupling effect of the current command component(s) 810, 812 (IxCmd, IyCmd) is illustrated. For example, in an embodiment, as shown, the control logic 800 receives a voltage command 802 (VdcCmd) via a voltage regulator 804. The voltage regulator 804 then generates an x component of an uncompensated current command 806 (IxCmdU). In addition, as shown, the control logic 800 generates a y component of an uncompensated current command 808 (IyCmdU). Thus, as shown at summators 814 and 816, the control logic 800 applies the first and second dynamic decoupling x- and y-factors 620, 638 by adding a product of the x and y components of the uncompensated current commands and the first dynamic decoupling x-factor and the second dynamic decoupling y-factor, respectively, to the current command calculation logic. Accordingly, as shown, the outputs of the summators 814, 816 correspond to the compensated current command components 810, 812 (IxCmd, IyCmd) that can be sent to the converter controller 209.

Furthermore, the skilled artisan will recognize the interchangeability of various features from different embodiments. Similarly, the various method steps and features described, as well as other known equivalents for each such methods and feature, can be mixed and matched by one of ordinary skill in this art to construct additional systems and techniques in accordance with principles of this disclosure. Of course, it is to be understood that not necessarily all such objects or advantages described above may be achieved in accordance with any particular embodiment. Thus, for example, those skilled in the art will recognize that the systems and techniques described herein may be embodied or carried out in a manner that achieves or optimizes one advantage or group of advantages as taught herein without necessarily achieving other objects or advantages as may be taught or suggested herein.

This written description uses examples to disclose the invention, including the best mode, and also to enable any person skilled in the art to practice the invention, including making and using any devices or systems and performing any incorporated methods. The patentable scope of the invention is defined by the claims.

## Claims

1. A method (500) for controlling a power generating asset having a generator, the generator having a stator operably coupled to a transformer and a rotor operably coupled to the transformer via a power converter, the method comprising:
using (502), via a controller, an angle of a phase-locked loop (PLL) reference signal of a PLL at a PLL reference node of the power generating asset to transform a three-phase set of signals to a two-dimensional orthogonal coordinate system of a synchronously-rotating frame, the two-dimensional orthogonal coordinate system comprising x and y components of at least one of voltage and current;
determining (504), via the controller, one or more dynamic decoupling factors as a function of one or more of the x and y components of voltage and current; and
applying (506), via the controller, the one or more dynamic decoupling factors to current command calculation logic to mitigate a coupling effect of one or more current command components.

2. The method of claim 1, further comprising determining, via the controller, a voltage magnitude of the PLL reference signal as a function of the x and y components of voltage.

3. The method of claim 2, wherein determining the voltage magnitude of the PLL reference signal as a function of the x and y components of the voltage further comprises:
determining a square root of a summation of the x and y components of voltage squared to determine the voltage magnitude.

4. The method of claim 3, wherein determining the one or more dynamic decoupling factors as a function of the one or more of the x and y components of at least one of voltage and current further comprises:
determining a first dynamic decoupling x-factor as a function of one or more of the x and y components of at least one of voltage and current; and
determining a second dynamic decoupling y-factor as a function of one or more of the x and y components of at least one of voltage and current.

5. The method of claim 4, wherein determining the first dynamic decoupling x-factor as a function of the one or more of the x and y components of at least one of voltage and current further comprises:
determining the first dynamic decoupling x-factor as a quotient of the x component of voltage over the voltage magnitude minus unity.

6. The method of claim 5, wherein determining the second dynamic decoupling y-factor as a function of the one or more of the x and y components of at least one of voltage and current further comprises:
determining the second dynamic decoupling y-factor as a quotient of the y component of voltage over the voltage magnitude.

7. The method of claims 4-6, wherein applying the one or more dynamic decoupling factors to the current command calculation logic to mitigate the coupling effect of one or more current command components further comprises:
observing an approach of the first dynamic decoupling x-factor and the second dynamic decoupling y-factor to zero as the x component of voltage aligns with an x-axis of the synchronously-rotating frame; and
if the first dynamic decoupling x-factor and the second dynamic decoupling y-factor both approach zero as the x component of voltage aligns with the x-axis of the synchronously-rotating frame, then the first dynamic decoupling x-factor and the second dynamic decoupling y-factor have no effect on the current command calculation logic.

8. The method of claim 7, wherein if the first dynamic decoupling x-factor and the second dynamic decoupling y-factor do not both approach zero as the x component of voltage aligns with the x-axis of the synchronously-rotating frame, then one or more feedback and reference node disparities exist in the power generating asset and the first dynamic decoupling x-factor and the second dynamic decoupling y-factor provide dynamic measures of how much one or more of the current command components needs to be adjusted in order to obtain a desired net current at the PLL reference node.

9. The method of any of the preceding claims, wherein applying the one or more dynamic decoupling factors to the current command calculation logic to mitigate the coupling effect of one or more current command components further comprises:
adding a product of one or more uncompensated commands and the first dynamic decoupling x-factor and the second dynamic decoupling y-factor to the current command calculation logic.

10. The method of any of the preceding claims, wherein determining the one or more dynamic decoupling factors as a function of the one or more of the x and y components of at least one of voltage and current further comprises:
at least one of clamping and filtering the one or more of the x and y components of at least one of voltage and current.

11. The method of any of the preceding claims, wherein the coupling effect of the one or more current command components occurs between active and reactive current command components.

12. A system for operating power generating asset, the system comprising:
a generator connected to a power grid; and
a controller communicatively coupled to the generator, the controller comprising at least one processor configured to perform a plurality of operations, the plurality of operations comprising:
using (502) an angle of a phase-locked loop (PLL) reference signal of a PLL at a PLL reference node of the power generating asset to transform a three-phase set of signals to a two-dimensional orthogonal coordinate system of a synchronously-rotating frame, the two-dimensional orthogonal coordinate system comprising x and y components of at least one of voltage and current;
determining (504) one or more dynamic decoupling factors as a function of one or more of the x and y components of at least one of voltage and current; and
applying (506) the one or more dynamic decoupling factors to current command calculation logic to mitigate a coupling effect of one or more current command components.

13. The system of claim 12, wherein the plurality of operations further comprise:
determining, via the controller, a voltage magnitude of the PLL reference signal as a function of the x and y components of voltage.

14. The system of claim 13, wherein determining the voltage magnitude of the PLL reference signal as a function of the x and y components of voltage further comprises:
determining a square root of a summation of the x and y components of voltage squared to determine the voltage magnitude.

15. The system of claims 13-14, wherein determining the one or more dynamic decoupling factors as a function of the one or more of the x and y components of at least one of voltage and current further comprises:
determining a first dynamic decoupling x-factor as a function of one or more of the x and y components of at least one of voltage and current; and
determining a second dynamic decoupling y-factor as a function of one or more of the x and y components of at least one of voltage and current.

## Patentansprüche

1. Verfahren (500) zum Steuern einer Energieerzeugungsanlage mit einem Generator, wobei der Generator einen Stator aufweist, der betriebsmäßig mit einem Transformator gekoppelt ist, und einen Rotor, der über einen Stromrichter betriebsmäßig mit dem Transformator gekoppelt ist, wobei das Verfahren umfasst:
Verwenden (502), über eine Steuerung, eines Winkels eines Phasenregelkreis-Referenzsignals eines Phasenregelkreises (PLL) an einem PLL-Referenzknoten der Energieerzeugungsanlage, um einen dreiphasigen Satz von Signalen in ein zweidimensionales orthogonales Koordinatensystem eines synchrondrehenden Rahmens zu transformieren, wobei das zweidimensionale orthogonale Koordinatensystem x- und y-Komponenten von mindestens einem aus Spannung und Strom umfasst;
Bestimmen (504), über die Steuerung, eines oder mehrerer dynamischer Entkopplungsfaktoren als Funktion einer oder mehrerer der x- und y-Komponenten von Spannung und Strom; und
Anwenden (506), über die Steuerung, des einen oder der mehreren dynamischen Entkopplungsfaktoren auf eine Strombefehls-Berechnungslogik, um einen Kopplungseffekt einer oder mehrerer Strombefehlskomponenten zu mildern.

2. Verfahren nach Anspruch 1, ferner umfassend das Bestimmen, über die Steuerung, einer Spannungsgröße des PLL-Referenzsignals als eine Funktion der x- und y-Komponenten der Spannung.

3. Verfahren nach Anspruch 2, wobei das Bestimmen der Spannungsgröße des PLL-Referenzsignals als Funktion der x- und y-Komponenten der Spannung ferner umfasst:
Bestimmen einer Quadratwurzel einer Summe der quadrierten x- und y-Komponenten der Spannung, um die Spannungsgröße zu bestimmen.

4. Verfahren nach Anspruch 3, wobei das Bestimmen des einen oder der mehreren dynamischen Entkopplungsfaktoren als Funktion der einen oder mehreren der x- und y-Komponenten von mindestens einem aus Spannung und Strom ferner umfasst:
Bestimmen eines ersten dynamischen Entkopplungs-x-Faktors als eine Funktion einer oder mehrerer der x- und y-Komponenten von mindestens einem aus Spannung und Strom; und
Bestimmen eines zweiten dynamischen Entkopplungs-y-Faktors als Funktion einer oder mehrerer der x- und y-Komponenten von mindestens einem aus Spannung und Strom.

5. Verfahren nach Anspruch 4, wobei das Bestimmen des ersten dynamischen Entkopplungs-x-Faktors als eine Funktion der einen oder mehreren der x- und y-Komponenten von mindestens einem aus Spannung und Strom ferner umfasst:
Bestimmen des ersten dynamischen Entkopplungs-x-Faktors als ein Quotient der x-Komponente der Spannung über der Spannungsgröße minus Eins.

6. Verfahren nach Anspruch 5, wobei das Bestimmen des zweiten dynamischen Entkopplungs-y-Faktors als Funktion der einen oder mehreren der x- und y-Komponenten von mindestens einem aus Spannung und Strom ferner umfasst:
Bestimmen des zweiten dynamischen Entkopplungs-y-Faktors als ein Quotient der y-Komponente der Spannung über der Spannungsgröße.

7. Verfahren nach den Ansprüchen 4-6, wobei das Anwenden des einen oder der mehreren dynamischen Entkopplungsfaktoren auf die Strombefehls-Berechnungslogik zur Milderung des Kopplungseffekts einer oder mehrerer Strombefehlskomponenten ferner umfasst:
Beobachten einer Annäherung des ersten dynamischen Entkopplungs-x-Faktors und des zweiten dynamischen Entkopplungs-y-Faktors an Null, wenn sich die x-Komponente der Spannung an einer x-Achse des synchrondrehenden Rahmens ausrichtet; und
wenn sich der erste dynamische Entkopplungs-x-Faktor und der zweite dynamische Entkopplungs-y-Faktor beide Null annähern, während sich die x-Komponente der Spannung an der x-Achse des synchrondrehenden Rahmens ausrichtet, dann haben der erste dynamische Entkopplungs-x-Faktor und der zweite dynamische Entkopplungs-y-Faktor keinen Einfluss auf die Strombefehls-Berechnungslogik.

8. Verfahren nach Anspruch 7, wobei, wenn sich der erste dynamische Entkopplungs-x-Faktor und der zweite dynamische Entkopplungs-y-Faktor nicht beide Null annähern, während sich die x-Komponente der Spannung an der x-Achse des synchrondrehenden Rahmens ausrichtet, eine oder mehrere Rückkopplungs- und Referenzknoten-Disparitäten in der Energieerzeugungsanlage existieren und der erste dynamische Entkopplungs-x-Faktor und der zweite dynamische Entkopplungs-y-Faktor dynamische Maße dafür liefern, wie stark eine oder mehrere der Strombefehlskomponenten angepasst werden müssen, um einen gewünschten Nettostrom am PLL-Referenzknoten zu erhalten.

9. Verfahren nach einem der vorhergehenden Ansprüche, wobei das Anwenden des einen oder der mehreren dynamischen Entkopplungsfaktoren auf die Strombefehls-Berechnungslogik zur Milderung des Kopplungseffekts einer oder mehrerer Strombefehlskomponenten ferner umfasst:
Hinzufügen eines Produkts aus einem oder mehreren unkompensierten Befehlen und dem ersten dynamischen Entkopplungs-x-Faktor und dem zweiten dynamischen Entkopplungs-y-Faktor zu der Strombefehls-Berechnungslogik.

10. Verfahren nach einem der vorhergehenden Ansprüche, wobei das Bestimmen des einen oder der mehreren dynamischen Entkopplungsfaktoren als Funktion der einen oder mehreren der x- und y-Komponenten von mindestens einem aus Spannung und Strom ferner umfasst:
mindestens eines aus Begrenzen und Filtern der einen oder mehreren der x- und y-Komponenten von mindestens einem aus Spannung und Strom.

11. Verfahren nach einem der vorhergehenden Ansprüche, wobei der Kopplungseffekt der einen oder mehreren Strombefehlskomponenten zwischen Wirk- und Blindstrombefehlskomponenten auftritt.

12. System zum Betreiben einer Energieerzeugungsanlage, wobei das System umfasst:
einen Generator, der mit einem Stromnetz verbunden ist; und
eine Steuerung, die kommunikativ mit dem Generator gekoppelt ist, wobei die Steuerung mindestens einen Prozessor umfasst, der so konfiguriert ist, dass er eine Vielzahl von Operationen ausführt, wobei die Vielzahl von Operationen umfasst:
Verwenden (502) eines Winkels eines Phasenregelkreis-Referenzsignals eines Phasenregelkreises (PLL) an einem PLL-Referenzknoten der Energieerzeugungsanlage, um einen dreiphasigen Satz von Signalen in ein zweidimensionales orthogonales Koordinatensystem eines synchrondrehenden Rahmens zu transformieren, wobei das zweidimensionale orthogonale Koordinatensystem x- und y-Komponenten von mindestens einem aus Spannung und Strom umfasst;
Bestimmen (504) eines oder mehrerer dynamischer Entkopplungsfaktoren als Funktion einer oder mehrerer der x- und y-Komponenten von mindestens einem aus Spannung und Strom; und
Anwenden (506) des einen oder der mehreren dynamischen Entkopplungsfaktoren auf eine Strombefehls-Berechnungslogik, um einen Kopplungseffekt einer oder mehrerer Strombefehlskomponenten zu mildern.

13. System nach Anspruch 12, wobei die Vielzahl von Operationen ferner umfasst:
Bestimmen, über die Steuerung, einer Spannungsgröße des PLL-Referenzsignals als Funktion der x- und y-Komponenten der Spannung.

14. System nach Anspruch 13, wobei das Bestimmen der Spannungsgröße des PLL-Referenzsignals als Funktion der x- und y-Komponenten der Spannung ferner umfasst:
Bestimmen einer Quadratwurzel einer Summe der quadrierten x- und y-Komponenten der Spannung, um die Spannungsgröße zu bestimmen.

15. System nach den Ansprüchen 13-14, wobei das Bestimmen des einen oder der mehreren dynamischen Entkopplungsfaktoren als Funktion der einen oder mehreren der x- und y-Komponenten von mindestens einem aus Spannung und Strom ferner umfasst:
Bestimmen eines ersten dynamischen Entkopplungs-x-Faktors als Funktion einer oder mehrerer der x- und y-Komponenten von mindestens einem aus Spannung und Strom; und
Bestimmen eines zweiten dynamischen Entkopplungs-y-Faktors als Funktion einer oder mehrerer der x- und y-Komponenten von mindestens einem aus Spannung und Strom.

## Revendications

1. Procédé (500) de commande d'un actif de production d'énergie ayant un générateur, le générateur ayant un stator couplé de manière opérationnelle à un transformateur et un rotor couplé de manière opérationnelle au transformateur par l'intermédiaire d'un convertisseur de puissance, le procédé comprenant :
l'utilisation (502), par l'intermédiaire d'un dispositif de commande, d'un angle d'un signal de référence de boucle à verrouillage de phase (PLL) d'une PLL au niveau d'un nœud de référence de PLL de l'actif de production d'énergie pour transformer un ensemble triphasé de signaux en un système de coordonnées orthogonales bidimensionnel d'un repère en rotation synchrone, le système de coordonnées orthogonales bidimensionnel comprenant des composantes x et y d'au moins l'un parmi une tension et un courant ;
la détermination (504), par l'intermédiaire du dispositif de commande, d'un ou plusieurs facteurs de découplage dynamique en fonction d'une ou de plusieurs des composantes x et y de tension et de courant ; et
l'application (506), par l'intermédiaire du dispositif de commande, du ou des facteurs de découplage dynamique à une logique de calcul de commande de courant pour atténuer un effet de couplage d'une ou plusieurs composantes de commande de courant.

2. Procédé selon la revendication 1, comprenant en outre la détermination, par l'intermédiaire du dispositif de commande, d'une amplitude de tension du signal de référence de PLL en fonction des composantes x et y de tension.

3. Procédé selon la revendication 2, dans lequel la détermination de l'amplitude de tension du signal de référence de PLL en fonction des composantes x et y de la tension comprend en outre :
la détermination d'une racine carrée d'une somme des composantes x et y de tension au carré pour déterminer l'amplitude de tension.

4. Procédé selon la revendication 3, dans lequel la détermination du ou des facteurs de découplage dynamique en fonction de la ou des composantes x et y d'au moins l'un parmi une tension et un courant comprend en outre :
la détermination d'un premier facteur x de découplage dynamique en fonction d'une ou plusieurs des composantes x et y d'au moins l'un parmi une tension et un courant ; et
la détermination d'un second facteur y de découplage dynamique en fonction d'une ou plusieurs des composantes x et y d'au moins l'un parmi une tension et un courant.

5. Procédé selon la revendication 4, dans lequel la détermination du premier facteur x de découplage dynamique en fonction de la ou des composantes x et y d'au moins l'un parmi une tension et un courant comprend en outre :
la détermination du premier facteur x de découplage dynamique sous la forme d'un quotient de la composante x de tension sur l'amplitude de tension moins l'unité.

6. Procédé selon la revendication 5, dans lequel la détermination du second facteur y de découplage dynamique en fonction de la ou des composantes x et y d'au moins l'un parmi une tension et un courant comprend en outre :
la détermination du second facteur y de découplage dynamique sous la forme d'un quotient de la composante y de tension sur l'amplitude de tension.

7. Procédé selon les revendications 4 à 6, dans lequel l'application du ou des facteurs de découplage dynamique à la logique de calcul de commande de courant pour atténuer l'effet de couplage d'une ou plusieurs composantes de commande de courant comprend en outre :
l'observation d'une approche du premier facteur x de découplage dynamique et du second facteur y de découplage dynamique vers zéro lorsque la composante x de tension s'aligne sur un axe x du repère en rotation synchrone ; et
si le premier facteur x de découplage dynamique et le second facteur y de découplage dynamique tendent tous deux vers zéro lorsque la composante x de tension s'aligne sur l'axe x du repère en rotation synchrone, alors le premier facteur x de découplage dynamique et le second facteur y de découplage dynamique n'ont aucun effet sur la logique de calcul de commande de courant.

8. Procédé selon la revendication 7, dans lequel si le premier facteur x de découplage dynamique et le second facteur y de découplage dynamique ne tendent pas tous deux vers zéro lorsque la composante x de tension s'aligne avec l'axe x du repère en rotation synchrone, alors une ou plusieurs disparités de nœud de rétroaction et de référence existent dans l'actif de production d'énergie et le premier facteur x de découplage dynamique et le second facteur y de découplage dynamique fournissent des mesures dynamiques de la quantité dont une ou plusieurs des composantes de commande de courant doivent être ajustées afin d'obtenir un courant net souhaité au niveau du nœud de référence de PLL.

9. Procédé selon l'une quelconque des revendications précédentes, dans lequel l'application du ou des facteurs de découplage dynamique à la logique de calcul de commande de courant pour atténuer l'effet de couplage d'une ou de plusieurs composantes de commande de courant comprend en outre :
l'ajout d'un produit d'une ou plusieurs commandes non compensées, du premier facteur x de découplage dynamique et du second facteur y de découplage dynamique à la logique de calcul de commande de courant.

10. Procédé selon l'une quelconque des revendications précédentes, dans lequel la détermination du ou des facteurs de découplage dynamique en fonction de la ou des composantes x et y d'au moins l'un parmi une tension et un courant comprend en outre :
au moins l'un parmi l'écrêtage et le filtrage d'une ou plusieurs des composantes x et y d'au moins l'un parmi une tension et un courant.

11. Procédé selon l'une quelconque des revendications précédentes, dans lequel l'effet de couplage de la ou des composantes de commande de courant se produit entre des composantes de commande de courant actif et réactif.

12. Système permettant d'exploiter un actif de génération de puissance, le système comprenant :
un générateur connecté à un réseau électrique ; et
un dispositif de commande couplé en communication au générateur, le dispositif de commande comprenant au moins un processeur configuré pour effectuer une pluralité d'opérations, la pluralité d'opérations comprenant :
l'utilisation (502) d'un angle d'un signal de référence de boucle à verrouillage de phase (PLL) d'une PLL au niveau d'un nœud de référence de PLL de l'actif de production d'énergie pour transformer un ensemble triphasé de signaux en un système de coordonnées orthogonales bidimensionnel d'un repère en rotation synchrone, le système de coordonnées orthogonales bidimensionnel comprenant des composantes x et y d'au moins l'un parmi une tension et un courant ;
la détermination (504) d'un ou plusieurs facteurs de découplage dynamique en fonction d'une ou plusieurs des composantes x et y d'au moins l'un parmi une tension et un courant ; et
l'application (506) du ou des facteurs de découplage dynamique à une logique de calcul de commande de courant pour atténuer un effet de couplage d'une ou de plusieurs composantes de commande de courant.

13. Système selon la revendication 12, dans lequel la pluralité d'opérations comprend en outre :
la détermination, par l'intermédiaire du dispositif de commande, d'une amplitude de tension du signal de référence de PLL en fonction des composantes x et y de tension.

14. Système selon la revendication 13, dans lequel la détermination de l'amplitude de tension du signal de référence de PLL en fonction des composantes x et y de tension comprend en outre :
la détermination d'une racine carrée d'une somme des composantes x et y de tension au carré pour déterminer l'amplitude de tension.

15. Système selon les revendications 13 à 14, dans lequel la détermination du ou des facteurs de découplage dynamique en fonction de la ou des composantes parmi les composantes x et y d'au moins l'un parmi une tension et un courant comprend en outre :
la détermination d'un premier facteur x de découplage dynamique en fonction d'une ou plusieurs des composantes x et y d'au moins l'un parmi une tension et un courant ; et
la détermination d'un second facteur y de découplage dynamique en fonction d'une ou plusieurs des composantes x et y d'au moins l'un parmi une tension et un courant.
